# EUROPÄISCHE PATENTSCHRIFT

(11) **EP 1 559 147 B1**
(45) Veröffentlichungstag und Bekanntmachung des Hinweises auf die Patenterteilung: **12.11.2014**
(21) Anmeldenummer: 03773464.7
(22) Anmeldetag: 30.09.2003
(51) Int. Cl.: H01L 51/40, H01L 27/00, H01L 51/05

(54) **FOLIE MIT ORGANISCHEN HALBLEITERN**
FILM COMPRISING ORGANIC SEMICONDUCTORS
FEUILLE CONTENANT DES SEMI-CONDUCTEURS ORGANIQUES

(30) Priorität: 02.10.2002 DE 10246241
(43) Veröffentlichungstag der Anmeldung: 03.08.2005
(60) Teilanmeldung: 10010395.1
(73) Patentinhaber: Leonhard Kurz Stiftung & Co. KG, 90763 Fürth (DE)
(72) Erfinder: LUTZ, Norbert, 90607 Rückersdorf (DE); WILD, Heinrich, 91074 Herzogenaurach (DE); BREHM, Ludwig, 91352 Adelsdorf (DE)
(74) Vertreter: Zinsinger, Norbert
(86) Internationale Anmeldenummer: PCT/DE2003/003258
(87) Internationale Veröffentlichungsnummer: WO 2004/032257

(56) Entgegenhaltungen:
- EP-A- 0 442 123
- WO-A-01/08241
- WO-A-99/44229
- DE-A- 10 219 905
- US-A1- 2003 134 487
- TZUNG-FANG GUO ET AL: "High performance polymer light-emitting diodes fabricated by a low temperature lamination process" ADV. FUNCT. MATER. (GERMANY), ADVANCED FUNCTIONAL MATERIALS, OCT. 2001, WILEY-VCH, GERMANY, Bd. 11, Nr. 5, Oktober 2001 (2001-10), Seiten 339-343, XP001083338 ISSN: 1616-301X

## Beschreibung

Organische Feldeffekttransistoren (OFETs) bestehen aus einer organischen Halbleiterschicht zwischen und über einer Source- und zumindest einer Drain-Elektrode, einer organischen Isolationsschicht über der halbleitenden Schicht und einer Gate-Elektrode. Source-, Drain- und Gate-Elektrode können aus Metallen oder aus organischen, leitfähigen Polymeren bestehen. Organische Elektrodenmaterialien sind beispielsweise Polyanilin und Polypyrrol. Als Halbleiter werden zum Beispiel Polythiophen, als Isolator Polyvinylphenol eingesetzt.

Zur Herstellung von OFETs oder anderen Bauelementen aus organischen Polymeren ist eine Strukturierung der leitfähigen Elektrodenschichten erforderlich. Die Strukturierung der anderen Schichten ist nicht unbedingt erforderlich, kann aber die Leistungsfähigkeit der Bauelemente aus organischen Polymeren verbessern.

WO 02/25750 beschreibt die Herstellung von Elektroden oder Leiterbahnen mit einem Lithographie-Verfahren. Hierbei wird die leitfähige organische Schicht aus dotiertem Polyanylin (PANI) oder Polyethylendioxythiophen (PEDOT) durch Rakeln, Aufsprühen, Spin-Coating oder Siebdruck flächig auf das Substrat, beispielsweise eine Folie, aufgebracht. Hierauf wird eine dünne Schicht aus Photoresist aufgebracht und strukturiert belichtet. Bei der Entwicklung wird die freigelegte Polyanilinschicht durch Einwirkung des Entwicklers deprotoniert und damit nichtleitend. Mit einem Lösungsmittel wird der verbliebene Photoresist gelöst. Vor oder nach diesem Schritt wird die nichtleitfähige Matrix der organischen Schicht mit einem nichtbasischen Lösungsmittel herausgelöst.

Alternativ ist es auch möglich, die freigelegten Bereiche vor dem Lösen des Photoresists durch reaktives Ätzen oxidativ zu entfernen.

WO 02/25750 beschreibt ferner, daß auf die flächige Funktionspolymerschicht eine chemische Verbindung, die deprotonierend wirkt, zur Strukturierung aufgedruckt wird. Die Verbindung ist bevorzugt eine Base. Durch eine anschließende Spülung werden nichtleitende Bereiche selektiv entfernt.

Es ist von Nachteil, daß das lithographische Verfahren nur für das Material Polyanilin funktioniert. Im Stand der Technik ist ferner nicht bekannt, Rollenware mit lithographischen Verfahren zu strukturieren. Mit anderen Strukturierungsverfahren, zum Beispiel Drucken, beträgt der minimal mögliche Abstand zwischen Source- und Drain-Elektrode zumindest 30 µm bis 50 µm. Angestrebt werden aber Längen von ungefähr 10 µm, um die Leistungsfähigkeit des OFET zu erhöhen.

WO 02/47183 schlägt für die Strukturierung der leitfähigen, organischen Schicht sowie der anderen Schichten in einem OFET vor, den Funktionspolymer in Vertiefungen einer Formschicht einzubringen. Die Formschicht besteht aus einem anderen organischen Material mit isolierenden Eigenschaften, in das ein Stempel eingedrückt wird. Dieses Material ist beispielsweise ein UV- oder ein thermisch härtbarer Lack, der vollflächig auf ein Substrat aufgebracht ist. Durch Bestrahlung, beispielsweise mittels UV-Licht, wird der Lack ausgehärtet und es werden in der Formschicht Vertiefungen erzeugt. In diese Vertiefungen wird dann das Funktionspolymer hineingerakelt. Mit diesem Verfahren können somit extrem feine Strukturen mit lateralen Abmessungen im Bereich von 2 - 5 µm erzeugt werden. Die Rakelmethode ist zudem nicht materialspezifisch, das heißt zur Strukturierung aller Schichten eines OFET geeignet. Neben Polyanylin können andere leitfähige oder halbleitende organische Materialien, wie beispielsweise Polypyrrol, Polythiophen oder auch Polyvinylphenol eingerakelt und somit strukturiert werden. Außerdem ist die Viskositätsspanne für das Rakeln ungleich größer als für das Drucken, so daß die Funktionspolymere weitgehend in ihrer Konsistenz belassen werden können. Zudem können relativ dicke Schichten im Bereich bis zu 1 µm erzeugt werden. Es wird ferner vorgeschlagen, das Verfahren im kontinuierlichen einzusetzen. Das Band besteht dabei aus einem Substratmaterial mit dem aufgebrachten Formpolymer, das ein UV-härtbarer, aber auch ein thermisch härtbarer Lack sein kann. Die Vertiefungen werden zunächst mit einer Stempelrolle eingeprägt und das Formpolymer durch UV-Bestrahlung angehärtet.

Mit einer danach angeordneten UV-Lampe wird der Lack nachgehärtet. In den strukturierten Lack wird dann das Funktionspolymer mit einem Rakel eingerakelt.

DE 10033112 beschreibt ein Verfahren, das das in die Form gefüllte Funktionspolymer mit Hilfe eines Tampons abnimmt und dann auf das Subtrat oder bereits vorhandene Schichten aufbringt.

Die US 2003/0134487 A1 betrifft ein Verfahren zum Bilden eines ebenen Polymertransistors. Das Polymer wird hierbei unter Einsatz eines lithographischen Verfahrens oder eines Druckverfahrens musterförmig aufgebracht. Die Schicht wird also strukturiert aufgebracht.

Die WO 02/47183 A1 offenbart ein Verfahren, bei dem eine Strukturierung einer Schicht durch thermische oder UV-Replikation erfolgt. Ein zunächst aufgebrachtes Formpolymer wird später repliziert. Beim Replizieren werden Aufnahmen bzw. Behältnisse bereitgestellt, die später dann von einem Funktionspolymer eingenommen werden. Die strukturierte Schicht ist also von der Funktionsschicht des Bauelements verschieden.

Die WO 01/08241 A1 beschreibt mehrere Verfahren zur Strukturierung von elektrischen Funktionsschichten. So wird u.a. beschrieben, durch partielles Aufbringen einer reaktiven Substanz oder durch partielle Bestrahlung die elektrischen Eigenschaften einer Funktionspolymerschicht partiell zu verändern. Zu einem Ausführungsbeispiel wird ein üblicher Schichtaufbau eines organischen Feldeffekttransistors mit strukturierten, auf einem Substrat aufgebrachten Funktionsschichten beschrieben, wobei diese Funktionsschichten und die zu selbigen benachbarten Schichten mittels einer Drucktechnik aufgebracht werden,

Die WO 99/44229 A1 offenbart ein Verfahren zur Herstellung elektrisch leitender oder halbleitender Strukturen in zwei oder drei Dimensionen innerhalb eines Bauelements. Bei der Diskussion des zugehörigen Standes der Technik wird auf MISFETs verwiesen, welche vollständig aus Polymeren oder unter Verwendung von Polymermaterial gebildet sind, und deren gewünschte elektrische Eigenschaft und Flächenausdehnung durch eine UV-Bestrahlung über eine Maske erreicht wird. Die Schicht wird dabei partiell chemisch verändert und in leitende und nicht-leitende Bereiche gegliedert. Als geeignetes Substrat und zum Auftrag der Polymermaterialien sind dabei Polyimid-Filme beschrieben.

Die EP 0 442 123 A1 beschreibt ein Verfahren zur Herstellung von elektronischen und opto-elektronischen Bauelementen und Schaltungen basierend auf einer Verbindung von zwei starren Glassubstraten durch schmelzflüssiges Polymer. Bei einem darin beschriebenen MISFET sind zwei Substrate, die jeweils bereits musterförmig mit Metallschichten bedampft sind, über ein geschmolzenes Polymer miteinander fest verbunden.

Der Erfindung liegt nun die Aufgabe zugrunde, die Herstellung leistungsfähiger Bauelemente in organischer Halbleitertechnologie zu verbessern und/oder den Aufbau verbesserter Bauelemente in organischer Halbleitertechnologie anzugeben.

Diese Aufgabe wird durch ein Verfahren zur Herstellung einer Folie, insbesondere einer Prägefolie, Laminierfolie oder eines Folienelements, gelöst, die mindestens ein Bauelement in organischer Halbleitertechnologie, insbesondere einen oder mehrere organische Feldeffekttransistoren (OFETs = OrganicFET), beinhaltet und wobei das Verfahren in Patentanspruch 1 angegeben ist. Bei dem Verfahren erfolgt die Strukturierung von einer oder mehreren Schichten des mindestens einen Bauelements in organischer Halbleitertechnologie durch thermisches Replizieren oder UV-Replizieren.

Durch die Herstellung von elektronischen Schaltungen in organischer Halbleitertechnologie nicht wie bisher üblich auf einem Wafer, sondern als Teil einer Folie, ergeben sich große produktionstechnische Vorteile. Bewährte und erprobte Methoden der Folientechnologie sowie bestehende Produktionsanlagen können für die Herstellung solcher elektronischen Schaltungen eingesetzt werden, wodurch sich erhebliche Kostenvorteile ergeben.

Besondere Vorteile ergeben sich bei der Implementierung solcher Bauelemente in organischer Halbleitertechnologie in Präge- oder Laminierfolien. Hierdurch wird die Möglichkeit eröffnet, derartige elektronische Schaltungen in vielfältiger Weise auf Produkten und Zwischenprodukten zu applizieren. Es wird ein kostengünstig zu produzierendes Zwischenprodukt geschaffen, das in vielfältiger Weise kundenspezifisch weiterverwendet und angepaßt werden kann. Der Fertigungsprozeß wird dadurch flexibilisiert und die Produktionskosten gesenkt. Weiter hat sich gezeigt, daß die für die Herstellung von Präge- und Laminierfolien verwendete Folientechnologie und Fertigungsverfahren besonders gut geeignet ist, derartige elektronische Schaltungen zu realisieren.
Gemäß einem bevorzugten Ausführungsbeispiel der Erfindung weist eine durch das Verfahren hergestellte derartige Prägefolie, eine Laminierfolie oder ein Folienelement eine Trägerfolie, zumindest eine Schicht aus einem organischen Halbleitermaterial, insbesondere Polythiophen, zumindestens eine Schicht aus einem elektrisch isolierenden Material und zwei oder mehr bereichsweise und musterförmig ausgeformte Schichten aus einem elektrisch leitfähigen Material auf, die als Elektrodenschichten wirken. Die elektrisch leitfähigen Schichten bestehen hierbei vorzugsweise aus einem organisch leitfähigen Material, insbesondere Polyanilin oder Polypyrol. Die elektrisch isolierende Schicht besteht vorzugsweise aus einem organischen Isolationsmaterial, insbesondere Polyvinylphenol. Weiter weist die hergestellte Folie bevorzugt eine Ablöseschicht und eine Klebeschicht, sowie eine oder mehrere an Funktionspolymerschichten angrenzende Lackschichten auf.

Weitere Vorteile sind dadurch erzielbar, daß die elektrisch leitfähige Schicht, die Schicht aus einem Halbleitermaterial und die Isolationsschicht in der Regel transparent sind. Hierdurch ist es möglich, das optische Erscheinungsbild der Folie durch die Gestaltung weiterer Schichten der Präge- oder Laminierfolie zu beeinflussen und eine Mehrfachnutzung der Folie z. B. als elektronische Schaltung und als dekoratives Element, zu vereinfachen.

Gemäß eines bevorzugten Ausführungsbeispiels der Erfindung wird in der hergestellten Folie eine elektrische Funktionalität, insbesondere die mindestens eines elektronischen Bauelements in organischer Halbleitertechnologie, mit optischen Merkmalen kombiniert. Die Folie weist demnach zum einen eine elektronische Schaltung mit einem oder mehreren elektronischen Bauelementen in organischer Halbleitertechnologie auf und bietet zum anderen dem Betrachter ein oder mehrere optische (Sicherheits-)merkmale. Hierzu kann die Folie beispielsweise eine zwischen Schichten der Folie abgeformte räumliche Struktur aufweisen, die zum einen eine Schicht eines elektronischen Bauelements in organischer Halbleitertechnologie musterförmig strukturiert und zum anderen einen beugungsoptischen Effekt generiert, der ein optisches Merkmal bildet. Die räumliche Struktur kann hierbei von der Überlagerung einer Makro- und einer Mikrostruktur gebildet werden, wobei die Makrostruktur für die musterförmige Strukturierung einer elektrischen Funktionsschicht und die Mikrostruktur für die Erzeugung eines beugungsoptischen Effekts und damit für die Generierung eines optischen (Sicherheits-)merkmals verantwortlich ist. Damit werden von einer räumlichen Struktur zwei Funktionen erbracht, zum einen die Implementierung eines elektronischen Bauelements in organischer Halbleitertechnologie und zum anderen die Generierung eines optischen Merkmals für den Betrachter der Folie.

Weiter kann die durch das Verfahren hergestellte Folie eine oder mehrere holographisch-optische oder diffraktive Schichten zur Erzeugung eines beugungsoptischen Sicherheitsmerkmals, eine oder mehrere Dünnfilmschichtfolgen zur Erzeugung eines optischen Sicherheitsmerkmals mittels Interferenz sowie eine oder mehrere Dekorschichten aufweisen, mittels denen zusätzlich zu der elektrischen Funktionalität eine optische Funktionalität, beispielsweise die Generierung ein oder mehrerer optischer (Sicherheits-)merkmale oder dekorativer Effekte, verwirklicht wird.

Eine derart ausgestaltete Folie kann so als optisches Sicherungselement, beispielsweise zur Sicherung von Ausweisen, Banknoten , Kreditkarten oder Geldkarten, sowie Waren dienen. Hierbei kann eine derartige Folie neben optischen Sicherheitsmerkmalen auch elektrische Sicherheitsmerkmale bieten. Durch die Kombination solcher optischen und elektrischen Sicherheitsmerkmale wird die Fälschungssicherheit erheblich erhöht. Weiter ist es auch möglich, daß die Folie zwei oder mehr übereinander angeordnete, ein optisches Sicherheitsmerkmal erzeugende Schichten aufweist, wobei eine oder mehrere Funktionsschichten eines elektronischen Bauelementes in organischer Halbleitertechnologie zwischen derartigen optisch aktiven Schichten angeordnet sind. Hierdurch wird die Fälschungssicherheit erheblich erhöht, da jeder Manipulationsversuch des optischen oder des elektrischen Sicherheitsmerkmals sofort erkennbar wird und sich diese Sicherheitsmerkmale so gegenseitig schützen.

Gemäß der Erfindung wird in die zu replizierende Schicht eine räumliche Struktur repliziert, deren Strukturtiefe größer oder gleich der Schichtdicke der zu replizierenden Schicht ist, so daß die zu replizierende Schicht partiell durch die Replikation vollständig durchtrennt ist. Durch die Replikation wird so eine gemäß der räumlichen Struktur musterförmig strukturierte elektrische Funktionsschicht geschaffen. Durch dieses Verfahren lassen sich sehr hohe Auflösungen, beispielsweise im Bereich von 10 µm bis 100 nm erzielen. Aufgrund der Möglichkeit derart kleine Strukturen realisieren zu können, läßt sich die Packungsdichte als auch die Leistungsfähigkeit der implementieren elektrischen Schaltungen verbessern. Weitere Vorteile dieses Verfahrens bestehen darin, daß in einem einzigen Schritt eine hochauflösende Strukturierung einer elektrischen Funktionsschicht möglich ist. Die Strukturierung der elektrischen Funktionsschicht kann mit hoher Geschwindigkeit , insbesondere als Rolle-zu-Rolle-Prozeß, und mit vergleichsweise geringen Produktionskosten erfolgen.

Gemäß eines vorliegend nicht beanspruchten Ausführungsbeispiels wird in die zu replizierende Schicht eine räumliche Struktur repliziert, deren Strukturtiefe kleiner als die Schichtdicke der zu replizierenden Schicht ist. Auf die replizierte Schicht wird eine elektrische Funktionsschicht aus einem Material aufgebracht, das bei Aushärtung eine vordefinierte Volumenreduktion erfährt. Dieses Material wird auf die replizierte Schicht in einer Auftragsmenge aufgebracht, die so gewählt ist, daß aufgrund des Volumenschrumpfes bei Aushärtung eine gemäß der replizierten Struktur musterförmig strukturierte Funktionsschicht verbleibt. Weiter ist es hier auch möglich, daß auf die replizierte Schicht eine elektrische Funktionsschicht aufgebracht wird und daß die elektrische Funktionsschicht anschließend in einer Tiefe abgetragen wird, die so gewählt ist, daß nach Abtragung eine der gemäß der replizierten Struktur musterförmig strukturierte

Funktionsschicht verbleibt. Auch mit einem derartigen Verfahren lassen sich hohe Auflösungen von elektrischen Funktionsschichten erreichen, so daß sich die hierzu oben beschriebenen Vorteile auch bei dieser Vorgehensweise ergeben.

Alternativ oder zusätzlich wäre es auch noch möglich, ein oder mehrere der für die Funktion der Bauelemente erforderlichen Elektroden-, Isolations- und halbleitenden Schichten durch Druckverfahren, insbesondere durch Tampondruck, teilflächig oder vollflächig in den Folienaufbau einzubringen.

Die Erfindung wird im folgenden anhand von mehreren Ausführungsbeispielen unter Zurhilfenahme der beiliegenden Zeichnungen beispielhaft beschrieben.
- Fig. 1: zeigt eine Schnittdarstellung einer durch das erfindungsgemäße Verfahren hergestellten Folie für ein erstes Ausführungsbeispiel.
- Fig. 2: zeigt eine Schnittdarstellung einer durch das erfindungsgemäße Verfahren hergestellten Folie für ein weiteres Ausführungsbeispiel.
- Fig. 3: zeigt eine Darstellung einer Vorrichtung zur Replikation von Strukturen elektrischer Bauelemente in organischer Halbleitertechnologie, insbesondere organischer Feldeffekttransistoren.
- Fig. 4a: zeigt eine funktionale Darstellung der Strukturierung einer Schicht eines Bauelements in organischer Halbleitertechnologie gemäß eines ersten Ausführungsbeispiels.
- Fig. 4b und 4c: zeigen funktionale Detaildarstellungen der Strukturierung einer Schicht gemäß dem ersten Ausführungsbeispiel.

- Fig. 5: zeigt eine Schnittdarstellung einer Folie, bei der ein oder mehrere Schichten eines Bauelements organischer Halbleitertechnologie gemäß dem Verfahren nach Fig. 4 repliziert sind.
- Fig. 6a bis Fig. 6e: zeigen Funktionsdarstellungen der Strukturierung von einer Schicht eines Bauelements in organischer Halbleitertechnologie durch Replikation gemäß einem weiteren Ausführungsbeispiel.
- Fig. 7: zeigt eine Schnittdarstellung einer Folie, bei der eine oder mehrere Schichten eines Bauelements in organischer Halbleitertechnologie gemäß den Verfahren nach Fig. 6a bis Fig. 6e strukturiert sind.
- Fig. 8a: zeigt eine funktionelle Darstellung der Replikation einer Schicht eines Bauelements in organischer Halbleitertechnologie gemäß einem weiteren Ausführungsbeispiel.
- Fig. 8b: zeigt eine funktionelle Darstellung der Replikation einer Schicht eines Bauelements in organischer Halbleitertechnologie gemäß einem weiteren Ausführungsbeispiel.
- Fig. 9a und Fig. 9b: zeigen Schnittdarstellungen durch das erfindungsgemäße Verfahren hergestellter Folien für ein weiteres Ausführungsbeispiel.

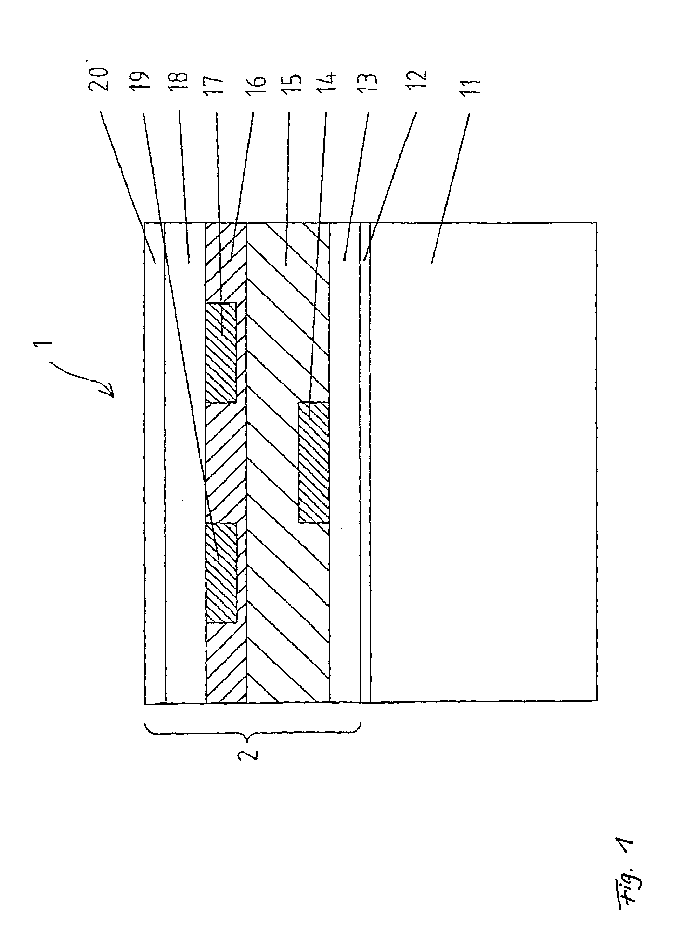

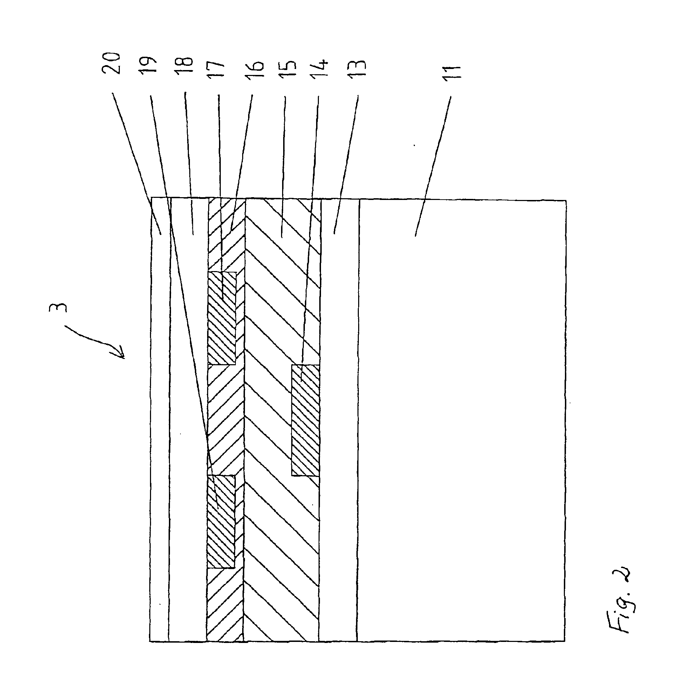

Fig. 1 zeigt eine Prägefolie, die zumindest ein Bauelement in organischer Halbleitertechnologie, insbesondere organische Feldeffekttransistoren (OFETs), beinhaltet. Bei einer solchen Prägefolie handelt es sich insbesondere um eine Heißprägefolie. Fig. 2 zeigt den Aufbau einer Laminierfolie, die mindestens ein Bauelement in organischer Halbleitertechnologie, insbesondere organische Feldeffekttransistoren (OFETs), beinhaltet. Die Erfindung ist jedoch nicht auf derartige Folientypen beschränkt.

Fig. 1 zeigt eine Prägefolie 1 mit einer Trägerfolie 11 und einer auf diese aufgebrachten Übertragungslage 2. Zwischen Trägerfolie 11 und Übertragungslage 2 ist eine Ablöseschicht 12 vorgesehen, die dazu dient, das Ablösen der Übertragungslage 2 von der Trägerfolie 11 zu erleichtern. Auf die Ablöseschicht 12 könnte hierbei auch verzichtet werden.

Die Übertragungslage 2 weist eine erste Lackschicht 13 und eine zweite Lackschicht 18, eine Isolationsschicht 15 aus einem elektrisch isolierenden Material und eine Schicht 16 aus einem organischen Halbleitermaterial auf. Weiter weist die Übertragungslage 2 zwei musterförmig ausgeformte Elektrodenschichten aus einem elektrisch leitfähigen Material auf, von denen in Fig. 1 ein Teilbereich 14, der eine Gate-Elektrode bildet, und zwei Teilbereiche 17 und 19, die eine Source-Elektrode bzw. eine Drain-Elektrode bilden, gezeigt sind.

Alternativ ist es auch möglich, die Anordnung der Gate- bzw. der Source- und Drain-Elektroden in der Übertragungslage 2 zu vertauschen, d.h. die Source- und Drain-Elektrode in der Zeichnung unten über der Lackschicht 13 und die Gate-Elektrode in der Zeichnung oben, neben und über der halbleitenden Schicht 16, vorzusehen.

Fig. 2 zeigt eine Laminierfolie 3 mit einem analogen Schichtaufbau. Der genaue Aufbau der Schichten wird so im folgenden lediglich anhand der Prägefolie 1 erläutert.

Bei der Trägerfolie 11 handelt es sich um eine Kunststofffolie mit einer Stärke von 6 µm bis 200 µm, vorzugsweise mit einer Stärke von 19 µm bis 38 µm. Bei der Trägerfolie 11 handelt es sich vorzugsweise um eine Polyesterfolie.

Auf die Trägerfolie 11 wird sodann vollflächig die Ablöseschicht 12 in einer Dicke von 0,01 bis 0,2 µm aufgebracht. Sie ist vorzugsweise als eine bei Wärmeentwicklung weich werdende Schicht ausgebildet, die beim Aufbringen der Heißprägefolie auf das Substrat die Ablösung der weiteren Schichten von der Trägerfolie 11 gestattet.

Bei der ersten Lackschicht 13 handelt es sich um eine Schutzlackschicht, die im allgemeinen vollflächig und zwar in einer Schichtdicke von 0,5 bis 5,0 µm, vorzugsweise von 1 bis 2 µm, auf die Ablöseschicht aufgebracht wird.

Auf die Lackschicht 13 wird nun die erste Elektrodenschicht mit der Gate-Elektrode 14 aufgebracht. Die erste Elektrodenschicht besteht hierbei vorzugsweise aus einem elektrisch leitfähigen Polymer, vorzugsweise Polyanilin und Polypyrrol. Weiter ist es möglich, für die erste Elektrodenschicht Metalle, beispielsweise Gold oder Silber, zu verwenden.

Die erste Elektrodenschicht kann hierbei beispielsweise durch ein Druckverfahren (Tiefdruck, Siebdruck) oder durch ein Beschichtungsverfahren bereits partiell und musterförmig auf die Lackschicht 13 aufgebracht werden. Es ist jedoch auch möglich, die erste Elektrodenschicht vollflächig oder teilflächig auf die Lackschicht 13 aufzubringen und sodann durch ein im späteren beschriebenes Replikationsverfahren, durch ein Belichtungs- und Ätzverfahren oder durch Ablation, beispielsweise mittels eines gepulsten Lasers, partiell wieder zu entfernen.

Je nach dem verwendeten Auftragsverfahren wird das elektrisch leitfähige Material hierbei in flüssiger Form, in gelöster Form oder als Suspension auf die Lackschicht 13 aufgebracht.

Die Isolationsschicht 15 besteht vorzugsweise aus einem organischen Isolationsmaterial, beispielsweise Polyvinylphenol. Es ist jedoch auch möglich, als Material für die Isolationsschicht 15 Oxidschichten, beispielsweise Metalloxide, zu verwenden. Organische Isolationsschichten werden hierbei mittels eines der oben beschriebenen Verfahren auf die musterförmig strukturierte Elektrodenschicht in flüssiger Form, gelöster Form oder als Suspension aufgebracht. Anschließend wird die Isolationsschicht 15 durch Trocknen oder in sonstiger Weise verfestigt. Oxidschichten werden durch thermisches Aufdampfen oder Sputtern im Vakuum aufgebracht.

Auf die Isolationsschicht 15 wird nun die Schicht 16 aus einem organischen Halbleitermaterial vollflächig oder teilflächig aufgebracht. Als organisches Halbleitermaterial kann hierbei Polythiophen verwendet werden. Das organische Halbleitermaterial wird hierbei mittels eines der oben beschriebenen Verfahren auf die Isolationsschicht 15 in flüssiger, gelöster Form oder als Suspension aufgebracht und sodann verfestigt. Hierbei ist es auch möglich, die Schicht 16 in gleicher Weise wie die erste Elektrodenschicht musterförmig zu strukturieren, wodurch sich die in Fig. 1 und Fig. 2 gezeigte Ausformung der Schicht 16 ergibt.

Anschließend wird die zweite Elektrodenschicht mit der Source- bzw. Drain-Elektrode 17 bzw. 19 in derselben Art und Weise wie oben beschrieben auf die Schicht 16 aufgebracht. In Bezug auf die für diese Schicht verwendeten Materialien und Strukturierungsverfahren wird auf die Ausführungen zu der ersten Elektrodenschicht verwiesen.

Anschließend werden die Lackschicht 18 und die Kleberschicht 20 vollflächig aufgebracht. Die Schichtdicke der Schicht 18 liegt vorzugsweise bei 2 - 10 µm. Bei der Kleberschicht 20 handelt es sich um eine bei Transferfolien bzw. Heißprägefolien an sich übliche und bekannte Kleberschicht einer Dicke von etwa 1 bis 10 µm, wobei die Kleberschicht für eine Heißprägefolie so zusammengesetzt ist, daß sie erst bei entsprechender Wärmeeinwirkung klebrig wird.

Die Schichten 12, 13, 18 und 20 können nach folgenden Rezepturen hergestellt sein:

### Ablöseschicht 12 (Trennschicht):

| | |
|---|---|
| Toluol | 99,5 Teile |
| Esterwachs (Tropfpunkt 90°C) | 0,5 Teile |
| Lackschicht 13 (Schutzlackschicht): | |
| Methylethylketon | 61,0 Teile |
| Diaketonalkohol | 9,0 Teile |
| Methylmethanacrylat (Tg = 122°C) | 18,0 Teile |
| Polyethylendispersion (23% in Xylol)(Erweichungspunkt 140°C) | 7,5 Teile |
| Hochmolekulares Dispergieradditiv (40 %, Aminzahl 20) | 0,5 Teile |
| Extender (Aluminiumsilikat) | 20,0 Teile |

### Lackschicht 18 (Zwischenschicht):

| | |
|---|---|
| Methylethylketon | 40,0 Teile |
| Toluol | 22,0 Teile |
| Ethylen-Vinylacetat-Terpolymer (Fp. = 60°C) | 2,5 Teile |
| Polyvinylchlorid (Tg: 89°C) | 5,5 Teile |
| Polyvinylchlorid (Tg: 40°C) | 3,0 Teile |
| Dispergieradditiv (50 %, Säurezahl 51) | 1,0 Teile |
| Titandioxid (d = 3,8 - 4,2 g/cm³) | 26,0 Teile |

### Kleberschicht 20:

| | |
|---|---|
| Methylethylketon | 55,0 Teile |
| Toluol | 12,5 Teile |
| Ethanol | 3,5 Teile |
| Polyvinylacetat (Erweichungspunkt 80°C) | 6,0 Teile |
| Butyl-/Methylmethacrylat (Tg: 80°C) | 8,0 Teile |
| Ethylmethacrylatharz (Tg: 63°C) | 3,0 Teile |
| Methacrylatcopolymere (Tg: 800C) | 5,0 Teile |
| Ungesättigtes Polyesterharz (Erweichungspunkt 103°C) | 3,5 Teile |
| Siliciumdioxid | 3,5 Teile |

Die Lackschichten 13 und 18 haben hier zum einen elektrisch isolierende Eigenschaften und haben im weiteren die Funktion von Schutzschichten für die von ihnen umschlossenen elektrischen Funktionspolymerschichten.

Auf die erste Lackschicht 13 und die zweite Lackschicht 18 könnte auch verzichtet werden.

Organische Halbleitermaterialien, organisch leitfähige Materialien und organische Isolationsmaterialien werden hierbei von organischen, metallorganischen und/oder anorganischen Kunststoffen gebildet, die die jeweiligen elektrischen Eigenschaften besitzen. Als Funktionspolymer werden hierbei solche organische, metallorganische und/oder anorganische Materialien bezeichnet, die bei dem Aufbau von Bauelementen in organischer Halbleitertechnologie Verwendung finden können. Der Begriff Funktionspolymer umfaßt demnach auch nichtpolymere Komponenten.

Der in Fig. 1 gezeigte Ausschnitt der Folie 1 weist die Gate-Elektrode 14, die Source-Elektrode 17 und die Drain-Elektrode 19 auf, so daß von dem in Fig. 1 gezeigten Bereich der Folie 1 durch das Zusammenwirken dieser Elektroden mit der Isolationsschicht 15 und der Schicht 16 aus einem organischen Halbleitermaterial ein organischer Feldeffekttransistor implementiert wird. Je nach Strukturierung der ersten und zweiten Elektrodenschicht sowie u. U. der ' Strukturierung der Isolationsschicht 15 und der Schicht 16 aus einem Halbleitermaterial kann in der Folie 1 eine komplexe elektronische Schaltung implementiert werden, die aus einer Vielzahl von Bauelementen in organischer Halbleitertechnologie besteht.

Unter Bauelement in organischer Halbleitertechnologie ist hierbei ein elektronisches Bauelement zu verstehen, das eine organische Halbleiterschicht oder Halbleiter-Schichtbereich als funktionelle Komponente umfaßt, beispielsweise Transistoren, FET's, Triacs, Dioden usw..

Hierbei ist es auch möglich, daß mehrere der in Fig. 1 dargestellten Schichten 13 bis 16 übereinander angeordnet sind, um so zwei oder mehr übereinander angeordnete Bauelemente in organischer Halbleitertechnologie in der Folie 1 zu verwirklichen.

Zur Verwirklichung der Bauelemente in organischer Halbleitertechnologie kann hierbei sowohl die erste Elektrodenschicht als auch die zweite Elektrodenschicht, wie bereits oben geschildert, in musterförmig strukturierter Form ausgebildet sein.

Es ist jedoch auch weiter möglich, daß auch die Isolationsschicht 15 und die Schicht 16 aus einem halbleitenden Material in musterförmig strukturierter Form ausgeführt ist, um die entsprechende elektrische Funktionalität zu erzielen. Für derartige musterförmige Strukturierungen werden hierbei folgende Verfahren oder eine Kombination folgender Verfahren vorgeschlagen:

Es wird vorgeschlagen, die für die Funktion der Bauelemente erforderlichen Elektroden-, Isolations- und halbleitenden Schichten durch Druckverfahren teilflächig oder vollflächig in einen Folienaufbau einzubringen.

Die für die teilflächige Bedruckung bekannten, hochauflösenden Druckverfahren weisen derzeit jedoch eine laterale Auflösung von 50 µm auf und sind daher für die Herstellung insbesondere der Source- und Drain-Elektroden nur bedingt geeignet.

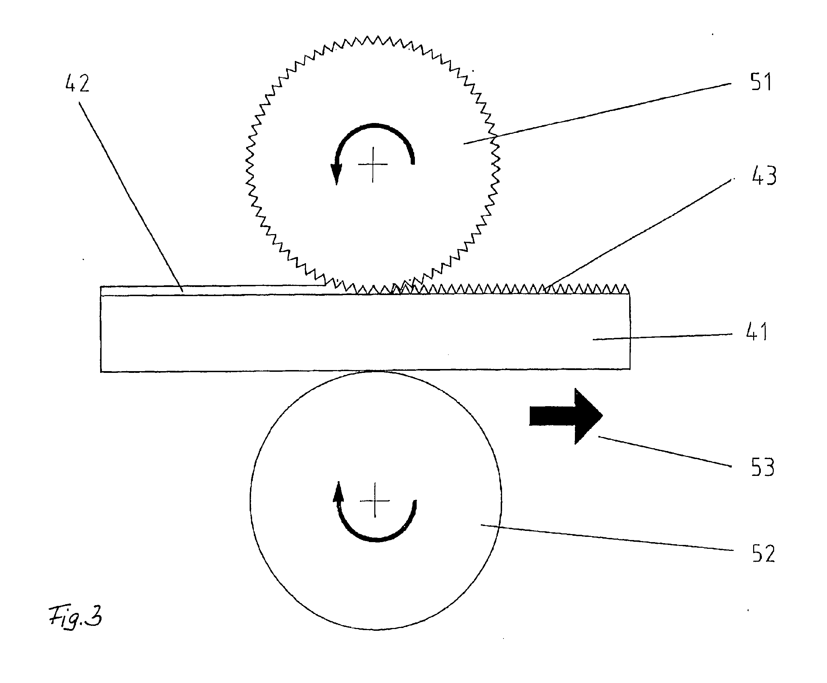

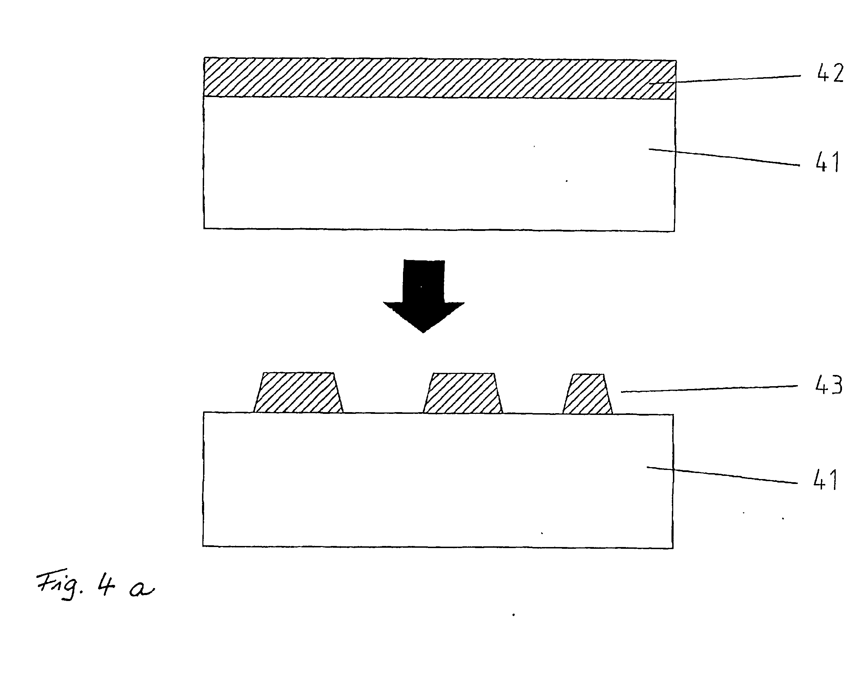

Bei dem hier bevorzugten Verfahren wird dagegen vorgesehen, zunächst eine vollflächige Bedruckung durchzuführen, und anschließend durch thermisches oder UV-Replizieren eine entsprechende Strukturierung der Schicht vorzunehmen. Eine entsprechende Vorrichtung hierfür ist in Fig. 3 gezeigt und das Resultat ist in Fig. 4a bis Fig. 4c dargestellt. Für die UV-Replikation ist zusätzlich eine nicht dargestellte UV-Lampe sowie eine ebenfalls nicht dargestellte Maske vorzusehen. Durch derartige Replizierverfahren werden sehr hohe laterale Auflösungen im Bereich von 0,5 µm bis 5 µm erreicht.

Fig. 3 zeigt eine Replizierwalze 51, eine Gegendruckwalze 52, eine Trägerfolie 41, eine Schicht 42 und eine strukturierte Schicht 43. Der Folienkörper, bestehend aus der Schicht 42 und der Trägerfolie 41, wird bei Drehung der Replizierwalze 51 und der Gegendruckwalze 52 in der in Fig. 3 angedeuteten Richtung in die Vorschubrichtung 53 befördert. Hierbei wird, wie in Fig. 3 gezeigt, eine Struktur in die Schicht 42 repliziert, so daß die Schicht 42 die in Fig. 3 gezeigte Struktur erhält und nun die strukturierte Schicht 43 bildet.

Bei der Schicht 42 handelt es sich um eine Funktionsschicht eines Bauelements in organischer Halbleitertechnologie, beispielsweise um eine Schicht des in Fig. 1 und Fig. 2 gezeigten organischen Feldeffekttransistors, beispielsweise um die erste Elektrodenschicht, die Schicht aus einem Isolationsmaterial, die zweite Elektrodenschicht oder die Schicht aus einem organischen Halbleitermaterial. Bei der Trägerfolie 41 kann es sich um die Trägerfolie 11 oder um einen mehrschichtigen Folienkörper mit der Trägerfolie 11 und einer oder mehreren darüberliegenden Schichten, beispielsweise um einen mehrschichtigen Folienkörper mit der Trägerfolie 11, der Ablöseschicht 12 und der Lackschicht 13 handeln.

Als Replikationsverfahren finden vorzugsweise thermische Replikation und UV-Replikation Anwendung.

Bei der thermischen Replikation erfolgt die Replikation durch thermische Verformung der Schicht 42. Für die Schicht 42 wird ein Material mit thermoplastischen Eigenschaften verwendet. Mittels der geheizten Replizierwalze 41 wird sodann eine Struktur in die Schicht 42 geprägt, die der Oberflächenform der Replizierwalze 51 entspricht.

Beispielsweise wird eine Polyanilin- oder Polypyrrol-Lösung mit einem Auftragsgewicht von 2,2 g/m² nach Trocknung auf den Folienkörper der Trägerfolie 41 mittels einer Tiefdruckrasterwalze aufgebracht. Die Trocknung erfolgt hierbei im Trockenkanal bei einer Temperatur von 100 bis 120 °C. In die Schicht 42 wird sodann bei etwa 130 °C mittels der beispielsweise aus Nickel bestehenden Replizierwalze die Struktur eingeprägt. Zum Prägen der Struktur wird die Replizierwalze hierbei vorzugsweise elektrisch aufgeheizt. Anstelle einer Replizierwalze ist es hier auch möglich, eine Replizier-Matrize zu verwenden. Eine derartige Matrize kann vor dem Abheben von der Schicht 42 wieder abgekühlt werden. Nach Einprägung der Struktur erhärtet die Schicht 43 sodann durch Vernetzung oder in sonstiger Weise.

Bei der UV-Replikation wird für die Schicht 42 ein UV-härtbares Material verwendet. Innerhalb der Replizierwalze 51 oder nach der Replizierwalze 51 wird eine UV-Lampe vorgesehen, die eine Aushärtung der gemäß der Oberflächenstruktur der Replizierwalze 51 geformten Schicht 43 bewirkt. Weiter ist es auch möglich, daß die Replizierwalze 51 über eine glatte Oberfläche verfügt, die in Form einer Maske die Schicht 42 partiell belichtet. In den belichteten Bereichen härtet die Schicht 42 aus. In den nicht belichteten Bereichen härtet die Schicht 42 nicht aus und wird in einem Waschprozeß entfernt, so daß sich die in Fig. 3 gezeigte Strukturierung der Schicht 43 ergibt.

Wie in Fig. 4a gezeigt, wird in die Schicht 42 hierbei eine räumliche Struktur repliziert, deren Strukturtiefe größer oder gleich der Schichtdicke der zu replizierenden Schicht ist. Die zu replizierende Schicht 42 wird so durch die Replikation partiell vollständig durchtrennt, wodurch sich eine gemäß der räumlichen Struktur musterförmig strukturierte elektrische Funktionsschicht 43 ergibt.

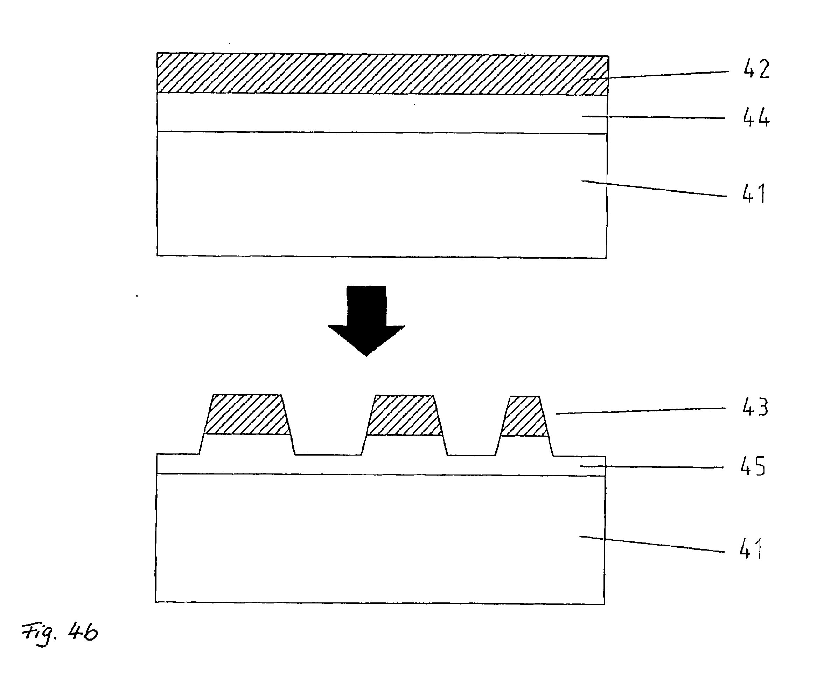

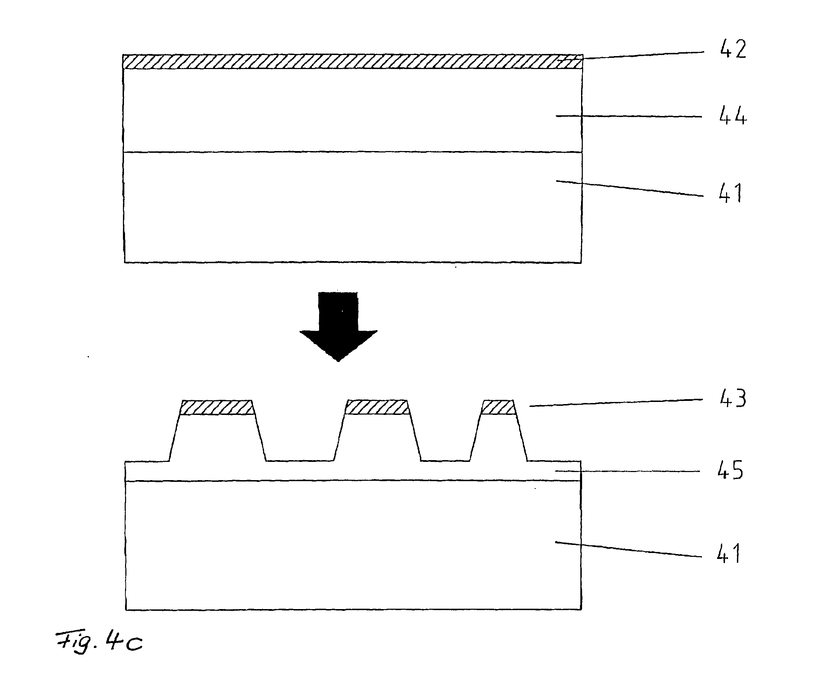

Hierbei ist es besonders bevorzugt, daß bei thermischer Replikation die Strukturtiefe größer als die Schichtdicke der Schicht 42 gewählt wird. Hierbei ist es vorteilhaft, wie in Fig. 4b gezeigt, unterhalb der Schicht 42 eine weitere Lackschicht 44, vorzugsweise aus einem Replizierlack aufzubringen. Die PrägeMatrize der Replizierwalze kann so die Schicht 42 durchprägen, ohne daß eine Schädigung der unterhalb der Lackschicht 44 liegenden Trägerfolie bzw. weiterer Schichten zu beobachten ist. In Fig. 4c ist eine Ausführungsform gezeigt, bei der die Dicke der Schicht 42 sehr viel kleiner als die Replikationstiefe gewählt ist. Hierdurch wird sichergestellt, daß eine zuverlässige Separierung der Bereiche der elektrischen Funktionsschicht 43 erreicht wird.

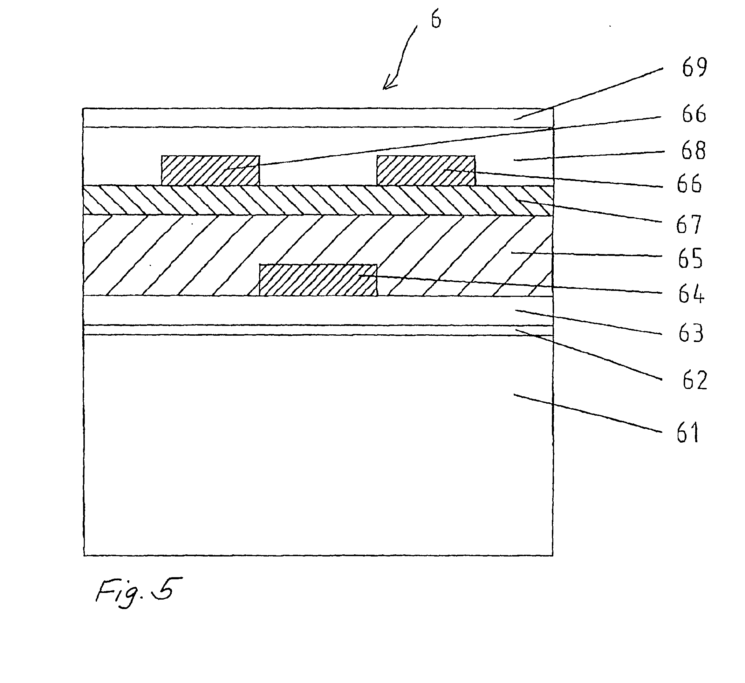

In Fig. 5 ist nun eine Prägefolie 6 dargestellt, bei der die erste und zweite Elektrodenschicht mittels des Verfahrens nach Fig. 3 bis Fig. 4c musterförmig strukturiert worden ist.

Fig. 5 zeigt die Prägefolie 6 mit einer Trägerfolie 61, einer Ablöseschicht 62, einer Lackschicht 63, einer ersten Elektrodenschicht 64, einer Isolationsschicht 65 einer Schicht 67 aus einem organischen Halbleitermaterial, einer zweiten Elektrodenschicht 66, einer Lackschicht 68 und einer Kleberschicht 69.

Die Lackschicht 63 besteht aus einem Replizierlack. Auf die Lackschicht 63 wird die erste Elektrodenschicht 64 vollflächig aufgebracht und sodann mittels des anhand von Fig. 3 und Fig. 4a, Fig. 4b oder Fig. 4c erläuterten Replikationsverfahren musterförmig strukturiert. Sodann wird die Isolationsschicht 65 vollflächig aufgebracht Anschließend erfolgt der vollflächige Auftrag der Schicht 67 aus einem organischen Halbleitermaterial. Hierauf wird eine zweite Elektrodenschicht 66 aufgebracht und wiederum mittels des Replizierverfahrens nach Fig. 3 bis Fig. 4c musterförmig strukturiert. Es ist auch möglich, die zweite Elektrodenschicht 66 partiell durch Druck- und Beschichtungsverfahren aufzubringen, insbesondere wenn Source- und Gate-Elektroden im Schichtaufbau unten und die Gate-Elektrode im Schichtaufbau oben angeordnet sind.

Anschließend erfolgt der vollflächige Auftrag der Schichten 68 und 69.

Wie bereits oben erläutert, ist es jedoch weiter möglich, sowohl die Isolationsschicht 65 als auch die Schicht 67 aus einem organischen Halbleitermaterial mittels der Verfahren nach Fig. 3 bis Fig. 4c musterförmig zu strukturieren und damit komplexere elektronische Schaltungen in der Prägefolie 6 zu implementieren.

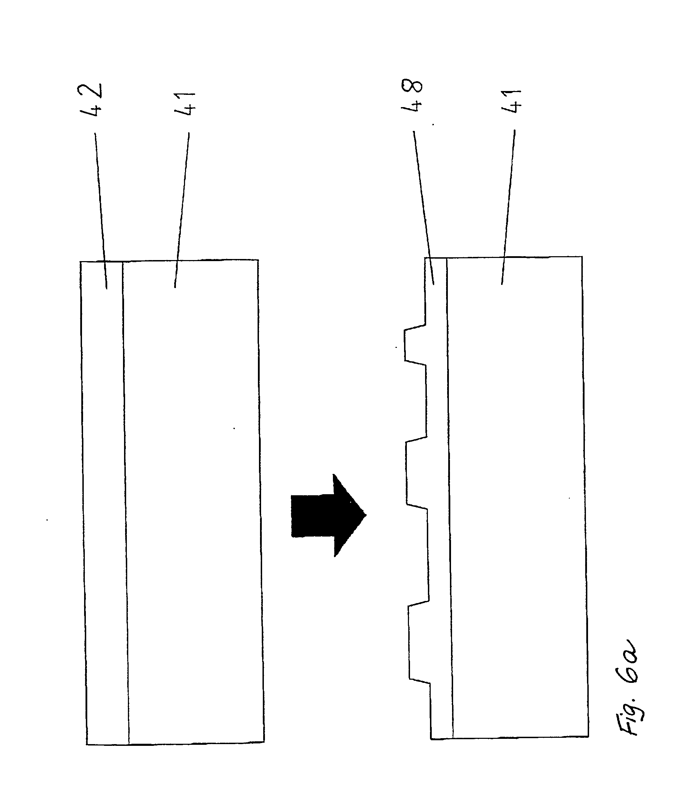

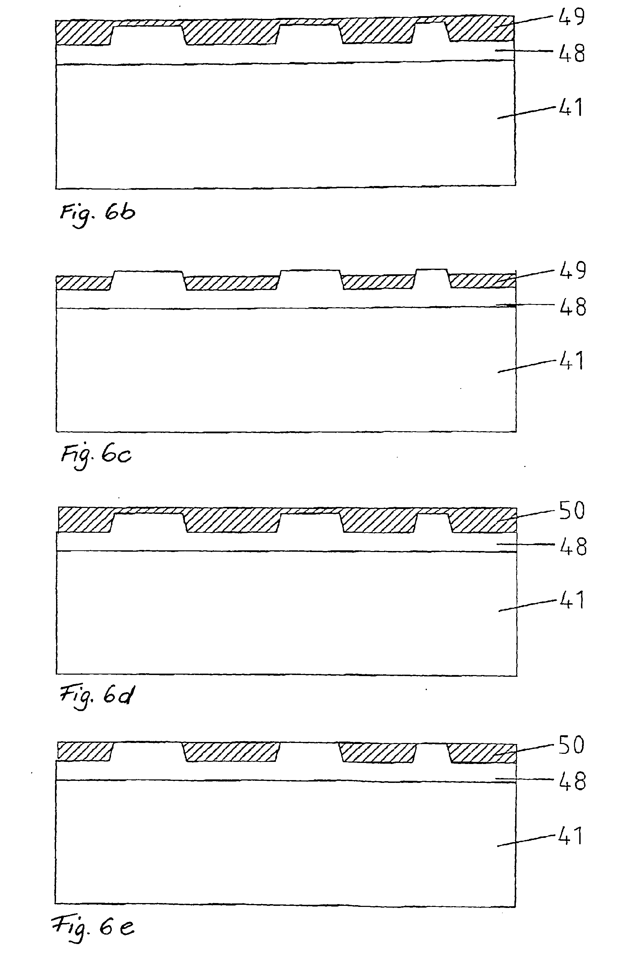

Weiter ist es auch möglich, daß in die zu replizierende Schicht eine räumliche Struktur repliziert wird, deren Strukturtiefe kleiner als die Schichtdicke der zu replizierenden Schicht ist. Dies ist beispielsweise in Fig. 6a dargestellt. In die Schicht 42 wird so mittels der anhand von Fig. 3 geschilderten Replizierverfahren eine Struktur repliziert, die die Schicht 42 nicht durchdringt und so die in Fig. 6a gezeigte Schicht 48 als Replikationsergebnis ergibt. In einem nächsten Schritt wird nun, wie in Fig. 6b gezeigt, eine elektrische Funktionsschicht 49 durch Aufdrucken, Beschichten oder Aufsprühen auf die strukturierte Schicht 48 aufgebracht. Für die elektrische Funktionsschicht 49 wird hierbei ein Material hoher Viskosität verwendet, so daß die Vertiefungen der Schicht 48 vollständig von der Schicht 49 ausgefüllt sind. Weiter wird ein Material für die elektrische Funktionsschicht 49 verwendet, das eine vordefinierte Volumenreduktion bei Aushärtung erfährt. So kann beispielsweise ein UV-aushärtbares Material verwendet werden, bevorzugt ein Acrylatsystem das bei UV-Aushärtung einen vorher klar definierten Volumenschrumpf erfährt. Weiter kann der Volumenschrumpf auch durch die Verdampfung des Lösungsmittels erzielt werden, in der das verwendete Funktionspolymer gelöst ist.

Das Material der Schicht 49 wird hierbei in einer Auftragsmenge pro Flächeneinheit aufgebracht, bei der zum einem die Vertiefungen der Schicht 48 vollständig von dem Material der Schicht 49 ausgefüllt sind, andererseits jedoch bei Aushärtung der Schicht 49 ein Volumenschrumpf erfolgt, der dazu führt, daß die Schicht 49 nunmehr die Vertiefungen der Schicht 48 ganz oder teilweise ausfüllt, nicht mehr jedoch die Plateaus der Schicht 48 bedeckt. Dies ist beispielsweise in Fig. 6c gezeigt, wo erkennbar ist, daß die Schicht 49 nach Aushärtung lediglich die Vertiefungen der Schicht 48 zu 95 % ausfüllt. Hierdurch wird erreicht, daß nach Aushärtung der Schicht 49 eine gemäß der replizierten Struktur musterförmig strukturierte elektrische Funktionsschicht 49 verbleibt.

Alternativ oder zusätzlich ist es auch möglich, wie in Fig. 6d gezeigt, eine elektrische Funktionsschicht 50 auf die Schicht 48 aufzubringen, die nach Aushärtung die Schicht 48 vollständig bedeckt und anschließend die Schicht 50, wie in Fig. 6e gezeigt, in einer Tiefe vollflächig abzutragen, daß eine gemäß der replizierten Struktur musterförmig strukturierte elektrische Funktionsschicht 50 verbleibt. Die Abtragung der Funktionsschicht 50 kann hier beispielsweise durch Ätzen oder ein sonstiges Ablationsverfahren, beispielsweise durch Laserablation, erfolgen.

Bei den Schichten 49 und 50 kann es sich jeweils um eine organische Isolationsschicht, eine Schicht aus einem organisch leitfähigen Material oder eine Schicht aus einem organischen Halbleitermaterial handeln, die als Funktionsschicht eines Bauelements in organischer Halbleitertechnologie verwendet wird. Bei der Schicht 48 kann es sich ebenfalls um eine derartige Funktionsschicht oder um eine Hilfsschicht handeln, die lediglich die Strukturierung einer elektrischen Funktionsschicht unterstützt.

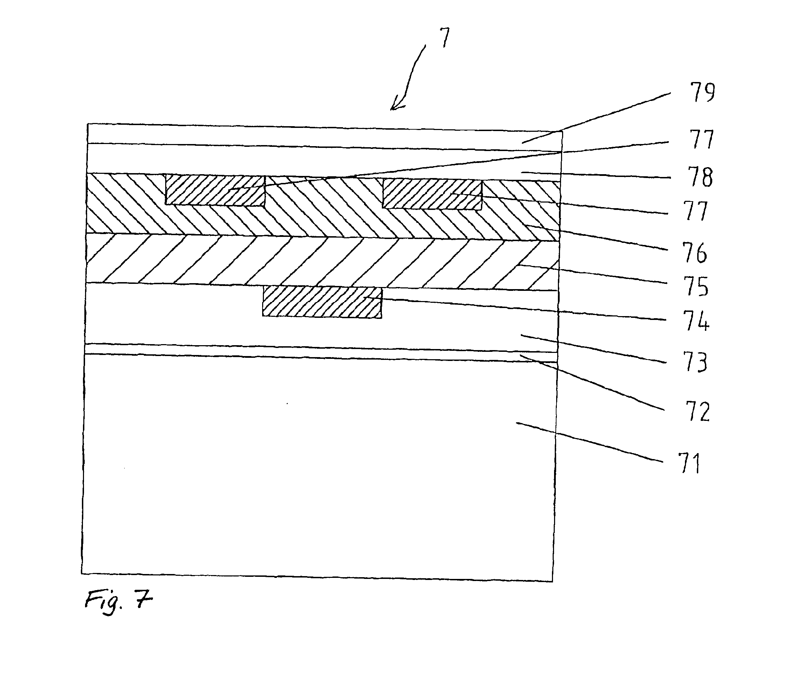

Fig. 7 zeigt nun ein Ausführungsbeispiel einer erfindungsgemäßen Folie, die über elektrische Funktionsschichten verfügt, die gemäß des anhand von Fig. 6a bis Fig. 6e erläuterten Verfahrens musterförmig strukturiert worden sind.

Fig. 7 zeigt eine Prägefolie 7 mit einer Trägerfolie 71, einer Ablöseschicht 72, einer Lackschicht 73, einer Isolationsschicht 75, einer Schicht 76 aus einem organischen Halbleitermaterial, zwei Elektrodenschichten 74 und 77, einer Lackschicht 78 und einer Kleberschicht 79.

Die Schicht 73 wird von einer Replizierlackschicht gebildet, die aus einem transparenten, thermoplatischen Kunststoffmaterial besteht.

Beispielsweise kann die Lackschicht 73 folgende Zusammensetzung besitzen:

| Komponente | Gewichtsteile |
|---|---|
| | |
| hochmolekulares PMMA-Harz | 2000 |
| Silikonalkyd ölfrei | 300 |
| nichtionisches Netzmittel | 50 |
| niedrigviskose Nitrocellulose | 750 |
| Methylethylketon | 1200 |
| Toluol | 2000 |
| Diacetonalkohol | 2500 |

In die Schicht 73 wird nun eine räumliche Struktur repliziert, die Schicht 74 aus einem organisch leitfähigen Material, beispielsweise Polyanilin oder Polypyrrol mittels eines Beschichtungsverfahrens aufgebracht und sodann ausgehärtet, so daß sich der anhand von Fig. 6b und Fig. 6c erläuterte Effekt ergibt. Anschließend wird die Isolationsschicht 75 vollflächig, beispielsweise mittels eines Druckverfahrens, aufgebracht. Die Isolationsschicht 75 kann hierbei aus dem selben Material wie die Lackschicht 73 bestehen. Anschließend erfolgt der vollflächige Aufdruck der Schicht 76 aus einem organischen Halbleitermaterial, beispielsweise Polythiophen. In die Schicht 76 wird nun eine Struktur repliziert, die Schicht 77 aus einem elektrisch leitfähigen Material aufgebracht und ausgehärtet, wobei sich der anhand der Fig. 6b und Fig. 6c erläuterte Effekt ergibt. Anschließend werden die Lackschichten 78 und die Kleberschicht 79 vollflächig, beispielsweise mittels einer Tiefdruckwalze, aufgedruckt.

Natürlich ist es auch denkbar, die im Stand der Technik beschriebene Formschicht durch Replizierverfahren herzustellen und anschließend mit dem Rakelverfahren die Strukturierung der OFET-Schichten vorzunehmen. Bezüglich dieses Standes der Technik wird auf den in der Beschreibungseinleitung angeführten Stand der Technik verwiesen.

Weiter sind natürlich zusätzliche, in den Figuren 1 und 2 nicht dargestellte Schichten, insbesondere holographisch-optische Schichten, optisch wirkende Dünnfilmschichten, Schutzschichten usw., vorstellbar.

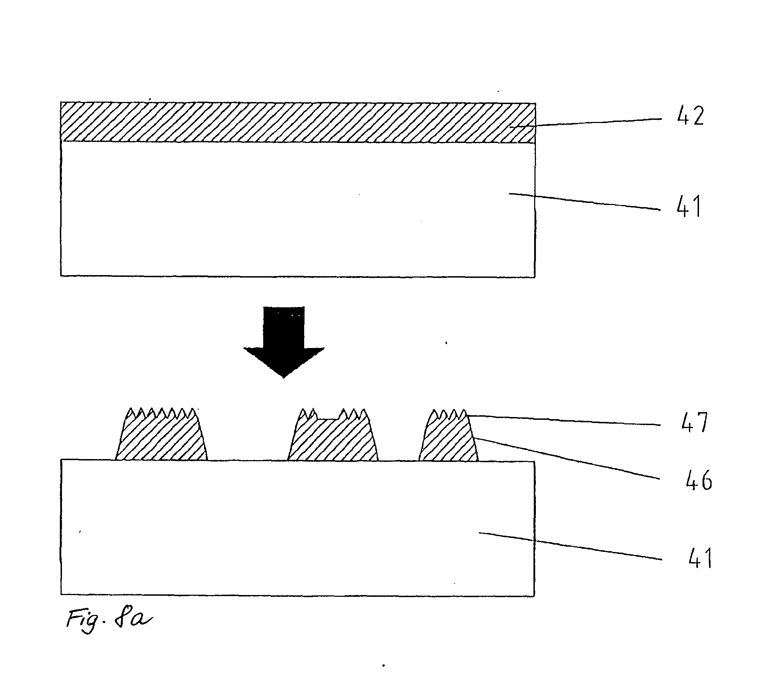

Hierbei ist es vorteilhaft, die elektrische Funktionalität (der organischen Halbleiterschaltung) mit optischen Merkmalen zu kombinieren. Beides wird in einem Schritt während des Repliziervorganges erzeugt, wie dies in Fig. 8a dargestellt ist. Es ist insbesondere denkbar, die mit den diffraktiv-optischen Strukturen versehenen Bauelementstrukturen so anzuordnen, daß ein besonderer optischer Eindruck, zum Beispiel ein Fimenlogo, entsteht. Eine besondere Fälschungssicherheit ergibt sich dadurch, daß die diffraktiven Strukturen in verschiedenen Höhenlagen des Schichtsystems, insbesondere auch übereinander, angeordnet sein können. Das sich so ergebende optisch-elektrische Element eignet sich demnach hervorragend als Sicherheitselement für Banknoten, Dokumente und zur Sicherung von Waren und Datenträgern gegenüber Fälschungen.

Fig. 8a zeigt nun die funktionelle Darstellung eines Repliziervorganges, bei dem gleichzeitig eine diffraktive, optische Struktur für ein optisches Sicherheitsmerkmal eingebracht wird und eine Strukturierung einer elektrischen Funktionsschicht erfolgt. Fig. 8a zeigt so die Trägerfolie 41 und die Schicht 42 nach Fig. 4a, Fig. 4b, Fig. 4c oder Fig. 6a. Wie in Fig. 8a gezeigt, wird in die Schicht 42 eine Struktur 47 repliziert, die sich aus der Überlagerung einer Makrostruktur und einer Mikrostruktur zusammensetzt. Die Makrostruktur führt zu einer musterförmigen Strukturierung der Schicht 42, so daß sich die musterförmig strukturierte, elektrische Funktionsschicht ergibt. Die Mikrostruktur beschreibt eine Feinstrukturierung der Oberfläche der replizierten Schicht 46. Die Mikrostruktur wird vorzugsweise von einer diffraktiv-optischen Struktur gebildet, die beispielsweise ein Hologramm oder beugungsoptische Effekte, wie Kinegram, Kineform und ähnliches, generiert. Bei der Mikrostruktur kann es sich natürlich auch um eine Beugungsstruktur nullter Ordnung handeln, die spezielle Farb- und Farbkippeffekte erzeugt. Weiter ist es auch möglich, daß die Mikrostruktur von einer isotropen oder anisotropen Mattstruktur gebildet wird.

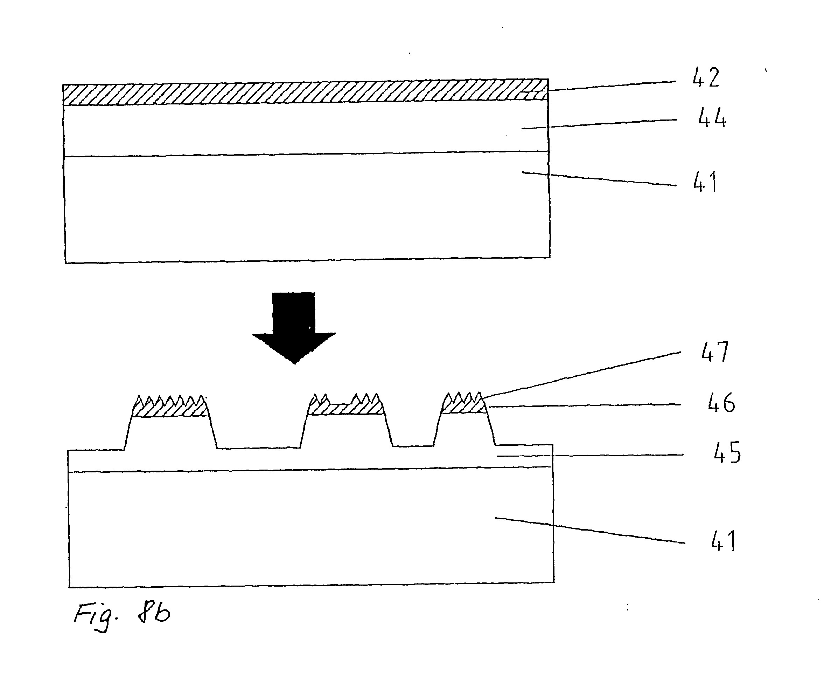

Dabei ist es besonders bevorzugt, daß bei thermischer Replikation die Strukturtiefe größer als die Schichtdicke der Schicht 42 gewählt wird. Hierbei ist es vorteilhaft, wie in Fig. 8b gezeigt, unterhalb der Schicht 42 eine weitere Lackschicht 44, vorzugsweise aus einem Replizierlack vorzusehen. Die Prägematrize der Replizierwalze kann so die Schicht 42 durchprägen, ohne daß eine Schädigung der unterhalb der Lackschichten 44 liegenden Trägerfolie bzw. weiterer Schichten zu beobachten ist.

Auf die Schicht 46 wird anschließend eine (Lack)-Schicht aus einem Material aufgebracht, dessen Brechungsindex sich von dem Brechungsindex des für die Schicht 46 verwendeten Materials deutlich unterscheidet, so daß die von der Mikrostruktur generierten optischen Effekte für einen Betrachter sichtbar werden. Alternativ kann zusätzlich eine Reflexionsschicht als vollständig oder partiell aufgebrachte Metallschicht oder HRI-Schicht auf die Schicht 46 aufgebracht werden (HRI = High Refraction Index). Als Materialien für die Reflexionsschicht kommen im wesentlichen Chrom, Aluminium, Kupfer, Eisen, Nickel, Silber, Gold oder eine Legierung mit diesen Materialien in Frage.

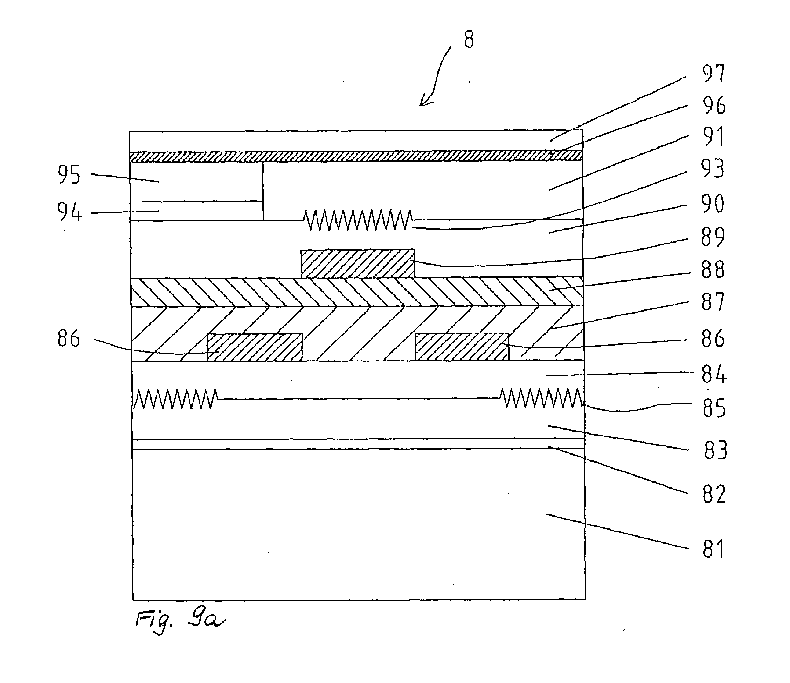

Fig. 9a zeigt nun eine weitere Möglichkeit, innerhalb einer Folie Funktionen eines elektronischen Bauelements in elektronischer Halbleitertechnologie mit optischen Sicherheitsmerkmalen zu kombinieren.

Fig. 9a zeigt eine Prägefolie 8 mit einer Trägerfolie 81, einer Ablöseschicht 82, zwei Lackschichten 83 und 84, einer ersten Elektrodenschicht 86, einer Isolationsschicht 87, einer Schicht 88, bestehend aus einem organischen Halbleitermaterial, einer zweiten Elektrodenschicht 89, einer Lackschicht 90, einer Lackschicht 91, einem Dünnfilmschichtsystem, bestehend aus einer Absorptionsschicht 94 und einer Distanzschicht 95, einer Reflexionsschicht 96 und einer Kleberschicht 97.

Die erste und zweite Elektrodenschicht 86 und 89, die Isolationsschicht 87 und die Schicht 88 aus einem organischen Halbleitermaterial sind wie die entsprechenden Schichten nach Fig. 1 und Fig. 2 ausgestaltet. Eine Strukturierung der Elektrodenschichten 86 und 89 kann beispielsweise mittels der anhand der Figuren Fig. 3 bis Fig. 4c beschriebenen Replizierverfahren erfolgen.

Bei der Schicht 83 handelt es sich um eine Replizierlackschicht, in die eine beugungsoptische Struktur 85 eingeprägt ist. Anschließend wird die Lackschicht 84 aufgebracht, die aus einem Material besteht, dessen Brechungsindex sich deutlich von dem Brechungsindex der Lackschicht 83 unterscheidet. Wie in Fig. 9a gezeigt, ist die Beugungsstruktur 85 nicht vollflächig, sondern partiell ausgeführt. Bei der Schicht 90 handelt es sich ebenfalls um eine Replizierschicht, in die eine beugungsoptische Struktur 93 eingeprägt ist. Auf die Schicht 90 wird partiell und musterförmig die Lackschicht 91 aufgebracht, deren Brechungsindex sich deutlich von dem Brechungsindex der Schicht 90 unterscheidet. Auch die beugungsoptische Struktur 93 ist lediglich partiell vorgesehen, so daß sich das von der beugungsoptischen Struktur 93 erzeugte optische Merkmal mit dem von der Struktur 85 erzeugten optischen Merkmal überlagert und ergänzt.

Das Dünnfilmschichtsystem besteht aus der Absorptionsschicht 94 (vorzugsweise mit 30 % bis 65 % Transmission), der transparenten Distanzschicht 85 als farbwechselerzeugende Schicht (z.B. A-viertel oder A-halbe Schicht) und der Reflexionsschicht 96 oder einer optischen Trennschicht, falls das Dünnfilmschichtsystem als transmittierendes Element wirken soll.

Die Schichten 94, 95 und 96 erzeugen eine blickwinkelabhängige Farbverschiebung mittels Interferenz. Die von dem Dünnfilmschichtsystem erzeugten Farbverschiebungen liegen hierbei vorzugsweise im Bereich des für einen menschlichen Betrachter sichtbaren Lichtes.

Weiter ist es möglich, ein Dünnfilmelement aus einer Abfolge von hoch- und niedrigbrechenden Schichten aufzubauen. Beispielsweise kann ein solches Dünnfilmelement aus drei bis neun solcher Schichten oder aus zwei bis zehn solcher Schichten aufgebaut sein. Je höher die Anzahl der Schichten ist, um so schärfer lassen sich die Wellenlängen für den Farbwechseleffekt einstellen.

Die Reflexionsschicht 96 kann als vollflächige oder partielle Metallschicht oder HRI-Schicht ausgebildet sein (HRI = High Refraction Index). Als Materialien für die Reflexionsschicht kommen so im wesentlichen Chrom, Aluminium, Kupfer, Eisen, Nickel, Silber, Gold oder eine Legierung mit diesen Materialien in Frage.

Weiter ist es auch möglich, daß die Lackschichten 83, 84, 90 und 91 eingefärbt sind. Die Schichten 86, 87, 88 und 89 sind vorzugsweise transparent oder vollflächig eingefärbt ausgeführt, so daß diese elektrischen Funktionsschichten den optischen Eindruck des Folienelements nicht beeinflussen. Weiter ist es natürlich auch möglich, daß bei der Replikation der Elektrodenschichten 86 und 87 ein Replikationsverfahren nach Fig. 8a oder Fig. 8b gewählt ist, so daß die bisher in Fig. 9a verdeutlichten optischen Effekte noch von zusätzlichen optischen Effekten überlagert werden. Auch hier ist es vorteilhaft, daß die so erzeugten optischen Effekte sich beispielsweise mit den von den diffraktiven Strukturen 85 und 93 erzeugten optischen Effekten ergänzen und dadurch eine Manipulation oder Änderung einer dieser Effekte für den Betrachter unmittelbar erkennbar wird.

Es ist natürlich auch möglich, daß in einer erfindungsgemäßen Folie nicht alle der anhand von Fig. 9a verdeutlichten optischen Effekte verwirklicht werden, sondern daß in einer solchen Folie nur eine Auswahl dieser Effekte implementiert wird.

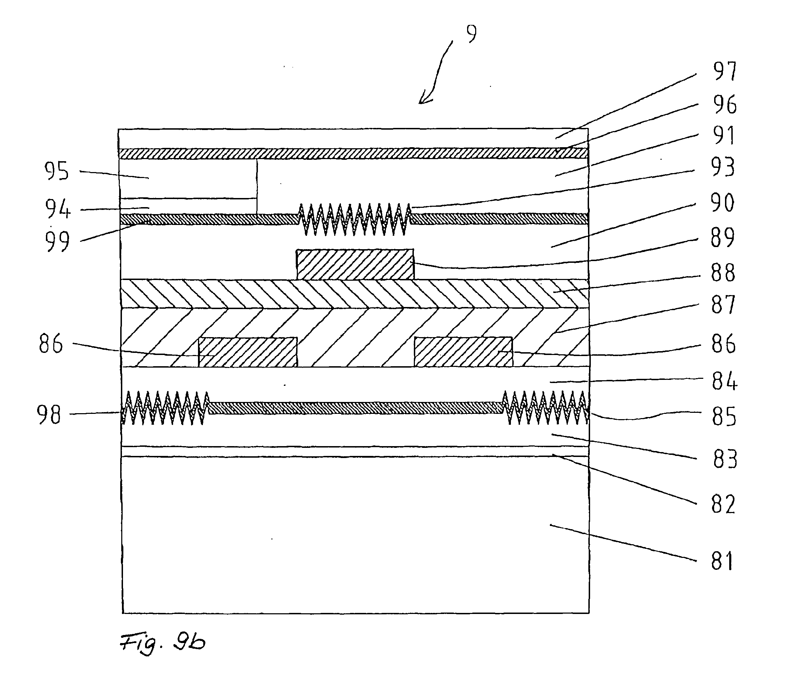

Fig. 9b zeigt eine Variante des Folienaufbaus, bei dem zusätzliche Reflexionsschichten 98 und 99 als Metallschichten oder HRI-Schichten vollflächig oder partiell auf die Schicht 83 bzw. die Schicht 90 aufgebracht sind. Hierbei ist es nicht erforderlich, daß sich die Brechungsindices der für die Schichten 84 bzw. 83 verwendeten Materialien unterscheiden. Ebenso ist es nicht erforderlich, daß sich die Brechungsindices der für die Schicht 90 bzw. die Schicht 91 verwendeten Materialien unterscheiden.

## Patentansprüche

1. Verfahren zur Herstellung einer Folie (1, 3, 6, 7, 8, 9), die mindestens ein elektronisches Bauelement in organischer Halbleitertechnologie beinhaltet,
**dadurch gekennzeichnet,**
**daß** eine Strukturierung von einer oder mehreren Schichten des mindestens einen Bauelements in organischer Halbleitertechnologie durch thermische Replikation oder UV-Replikation erfolgt, indem in eine zu replizierende, vorhandene Schicht (42) eine räumliche Struktur repliziert wird, deren Strukturtiefe größer oder gleich der Schichtdicke der zu replizierenden Schicht (42) ist, so daß die vorhandene zu replizierende Schicht (42) durch die Replikation vollständig durchtrennt wird und so eine gemäß der räumlichen Struktur in Bereiche separierte musterförmig strukturierte elektrische Funktionsschicht (43) gebildet wird.

2. Verfahren nach Anspruch 1,
**dadurch gekennzeichnet,**
**daß** die räumliche Struktur in eine Elektrodenschicht aus einem elektrisch leitfähigen Material repliziert wird, auf diese Schicht sodann eine elektrische Funktionsschicht aus einem nichtleitenden oder halbleitenden Material aufgebracht wird.

3. Verfahren nach Anspruch 1,
**dadurch gekennzeichnet,**
**daß** alle oder ein oder mehrere für die Funktion des mindestens einen Bauelements in organischer Halbleitertechnologie erforderlichen Elektroden-, Isolations- und halbleitenden Schichten durch Druckverfahren teilflächig oder vollflächig in einen Folienaufbau eingebracht werden.

4. Verfahren nach einem der Ansprüche 1 bis 3,
**dadurch gekennzeichnet,**
**daß** durch einen Repliziervorgang ein oder mehrere Bauelemente in organischer Halbleitertechnologie und eine optische Funktionalität, insbesondere diffraktivoptische Strukturen, erzeugt werden.

## Claims

1. Method for the production of a film (1, 3, 6, 7, 8, 9) that contains at least one component in organic semi-conductor technology,
**characterised in that**,
a structuring of one or more layers of the at least one component in organic semi-conductor technology takes place by thermal replication or UV replication by a spatial structure being replicated into a layer (42) that is to be replicated, the structural depth of which is greater than or equal to the layer thickness of the layer (42) that is to be replicated, such that the existing layer (42) to be replicated is completely severed by the replication and thus a separate, structured, electrical functional layer (43) that is separated in a patterned manner into regions according to the spatial structure is formed.

2. Method according to claim 1,
**characterised in that**,
the spatial structure is replicated into an electrode layer made from an electrically conductive material, with an electrical functional layer made from a non-conductive or semi-conductive material then being applied to this layer.

3. Method according to claim 1,
**characterised in that**,
all or one or more electrode, insulating and semi-conductor layers necessary for the function of the at least one component in organic semi-conductor technology are introduced into a film structure by printing methods either over part of the surface or the entire surface.

4. Method according to one of claims 1 to 3,
**characterised in that**,
one or more components in organic semi-conductor technology and an optical functionality, in particular diffractive optical structures, are generated by a replication process.

## Revendications

1. Procédé servant à fabriquer un film (1, 3, 6, 7, 8, 9), qui comporte au moins un composant électronique relevant de la technologie des semi-conducteurs organiques,
**caractérisé en ce que**
une structuration d'une ou de plusieurs couches du composant au moins au nombre de un relevant de la technologie des semi-conducteurs organiques est effectuée par réplication thermique ou par réplication infrarouge, **en ce qu'**une structure spatiale est répliquée dans une couche (42) présente à répliquer, la profondeur de ladite structure spatiale étant plus grande que l'épaisseur de couche de la couche (42) à répliquer ou égale à cette dernière, de sorte que la couche (42) présente à répliquer est intégralement séparée par la réplication, ce qui permet de former ce faisant une couche fonctionnelle (43) électrique structurée de manière à former un motif, séparée en zones conformément à la structure spatiale.

2. Procédé selon la revendication 1,
**caractérisé en ce que**
la structure spatiale est répliquée dans une couche d'électrodes constituée d'un matériau électroconducteur, une couche fonctionnelle électrique constituée d'un matériau non conducteur ou semiconducteur étant alors appliquée sur ladite couche.

3. Procédé selon la revendication 1,
**caractérisé en ce que**
l'intégralité des couches d'électrodes, des couches isolantes et des couches semi-conductrices ou une seule couche d'électrodes, une seule couche isolante et une seule couche semi-conductrice ou plusieurs de ces dernières, lesquelles sont nécessaires au fonctionnement du composant au moins au nombre de un relevant de la technologie des semi-conducteurs organiques sont intégrées dans une structure de film, sur une surface partielle ou sur la totalité de la surface, par des procédés d'impression.

4. Procédé selon l'une quelconque des revendications 1 à 3,
**caractérisé en ce que**
sont générés par une opération de réplication un ou plusieurs composants relevant de la technologie des semi-conducteurs organiques et une fonctionnalité optique, en particulier des structures de diffraction optique.
